# EUROPEAN PATENT APPLICATION

(11) **EP 2 463 409 A1**
(43) Date of publication of application: **13.06.2012**
(21) Application number: 10770936.2
(22) Date of filing: 08.03.2010
(51) Int. Cl.: C25B 11/08, C23C 14/14, C25B 1/28

(54) **ELECTRODE MATERIAL FOR ELECTROLYSIS, ELECTRODE FOR ELECTROLYSIS, AND METHOD FOR PRODUCING SAME**

(30) Priority: 30.07.2009 JP 2009177971
(71) Applicant: Sanyo Electric Co., Ltd., Osaka 570-8677 (JP)
(72) Inventor: NEMOTO, Masaaki, Moriguchi-shi Osaka 570-8677 (JP)
(74) Representative: Glawe, Delfs, Moll
(86) International application number: PCT/JP2010/001604
(87) International publication number: WO 2011/013261

(57) **Abstract**

There are disclosed a material of an electrode for electrolysis which can highly efficiently generate an ozone water by the electrolysis of water, an electrode for electrolysis, and a manufacturing method of the electrode for electrolysis. The material of the electrode for electrolysis which is an alloy comprising platinum and silver and having a concentration of silver from 1 wt% or more to 50 wt% or less is used as a surface layer formed on the surface of a base member, whereby in the electrolysis by the electrode for electrolysis, active oxygen species such as ozone and OH radicals can efficiently be generated with a low current density.

## Description

### Technical Field

The present invention relates to an electrode for electrolysis used in an industrial or household electrolysis process, a material of the electrode and a manufacturing method of the electrode for electrolysis.

### Background Art

In general, ozone is a very strongly oxidative substance, and water containing dissolved ozone, a so-called ozone water, is expected for broad washing and sterilization treatments, for example, in water and sewerage, foods, a washing treatment in a semiconductor device manufacturing process, and others. As a method of generating the ozone water, a method of dissolving, in water, ozone generated by ultraviolet irradiation or electric discharge, a method of generating ozone in water by electrolysis of the water or the like is known.

In Patent Document 1, the method of generating ozone in the water by the electrolysis of the water is disclosed. In such a method, a porous or mesh member made of PbO₂ or platinum is used as an anode.

### Prior Art Reference

### Patent Document

Patent Document 1: Japanese Patent No. 3297227

### Summary of the Invention

### Problem to be solved by the Invention

In the above generation method of an ozone water by electrolysis of water, when PbO₂ is used as an electrode material and the generated ozone water is used for foods and the like, toxicity of PbO₂ is feared. On the other hand,'when platinum (Pt) is used as the electrode material, there occurs a problem that the electrolysis of the water with a low current density has a low ozone generation efficiency. Therefore, when ozone is generated by the electrolysis, it is necessary to use a method in which a zero gap is acquired and a large current is allowed to flow. To acquire the zero gap, platinum needs to be processed into a mesh or porous material. However, platinum itself is comparatively expensive, and platinum further needs to be processed into the mesh or porous material, which incurs steep rise of production cost. In consequence, there has been desired development of the material of the electrode for electrolysis which enables more inexpensive, stable and efficient generation of ozone.

The present invention has been developed to solve a conventional technical problem, and an object thereof is to provide a material of an electrode for electrolysis which enables highly efficient generation of an ozone water by electrolysis of water, an electrode for electrolysis and a manufacturing method of the electrode for electrolysis.

### Means for solving the Problem

To solve the above problem, a material of an electrode for electrolysis of the present invention is an alloy comprising platinum and silver, **characterized in that** concentration of silver is from 1 wt% or more to 50 wt% or less.

A material of an electrode for electrolysis of a second aspect of the present invention is an alloy comprising platinum, silver and oxygen, **characterized in that** concentration of silver in platinum and silver is from 1 wt% or more to 50 wt% or less.

An electrode for electrolysis of a third aspect of the present invention comprises a base member and a surface layer formed on the surface of this base member, **characterized in that** the surface layer is made of an alloy comprising platinum and silver, and concentration of silver is from 1 wt% or more to 50 wt% or less.

An electrode for electrolysis of a fourth aspect of the present invention generates active oxygen species such as ozone and OH radicals by the electrolysis, the electrode comprising a base member and a surface layer formed on the surface of this base member, **characterized in that** the surface layer is made of an alloy comprising platinum, silver and oxygen, and concentration of silver in platinum and silver is from 1 wt% or more to 50 wt% or less.

The invention of a fifth aspect is a manufacturing method of the electrode for electrolysis of the invention of the third aspect, characterized by forming the surface layer by a sputtering process to form a film on the surface of the base member by use of a target including platinum and silver.

The invention of a sixth aspect is a manufacturing method of the electrode for electrolysis of the invention of the fourth aspect, characterized by forming the surface layer by a sputtering process to form a film on the surface of the base member in an atmosphere including oxygen by use of a target including platinum and silver.

### Advantage of the Invention

According to the present invention, the material of the electrode for electrolysis which is the alloy comprising platinum and silver and having the concentration of silver from 1 wt% or more to 50 wt% or less is used as the surface layer formed on the surface of the base member as in the invention of the third aspect, whereby active oxygen species such as ozone and OH radicals can be generated with a high current efficiency in the electrolysis by the electrode for electrolysis. Therefore, as compared with conventional Pt, the amount of power necessary for generating the same amount of ozone can be decreased, which can contribute to energy saving. Moreover, as compared with an electrode for electrolysis having an equal dimension, active oxygen species such as ozone and OH radicals can efficiently be generated with a small current density, the electrode wears less, and durability can be improved. When an electrolysis treatment is performed with the same current density, the dimension of the electrode for electrolysis itself can be decreased. Moreover, since the electrode wears less, the surface layer can be formed of a thinner film.

In this case, as compared with a case where only platinum is used as the material of the electrode for electrolysis used in the surface layer as in a conventional example, active oxygen species such as ozone and OH radicals can efficiently be generated. Moreover, the concentration (the component ratio) of comparatively expensive platinum can be decreased, which can lower production cost.

As in the manufacturing method of the invention of the fifth aspect, such an electrode for electrolysis is manufactured by forming the surface layer by the sputtering process to form the film on the surface of the base member by use of the target including platinum and silver, whereby the surface layer made of the alloy comprising platinum and silver can uniformly be formed on the surface of the base member. In consequence, the surface layer made of the alloy comprising platinum and silver and having a uniform thickness can be formed on the whole surface of the base member, whereby electricity can evenly be conducted over the whole surface of the electrode. This enhances the efficiency of the generation of active oxygen species such as ozone and OH radicals.

Moreover, according to the invention of the second aspect, the material of the electrode for electrolysis which is the alloy comprising platinum, silver and oxygen and having the concentration of silver in platinum and silver from 1 wt% or more to 50 wt% or less is used as the surface layer formed on the surface of the base member as in the invention of the fourth aspect, whereby active oxygen species such as ozone and OH radicals can be generated with the high current efficiency in the electrolysis by the electrode for electrolysis. Therefore, as compared with conventional Pt, the amount of power necessary for generating the same amount of ozone can be decreased, which can contribute to energy saving. Moreover, as compared with an electrode for electrolysis having an equal dimension, active oxygen species such as ozone and OH radicals can efficiently be generated with a small current density, the electrode wears less, and durability can be improved. When an electrolysis treatment is performed with the same current density, the dimension of the electrode for electrolysis itself can be decreased. Moreover, since the electrode wears less, the surface layer can be formed of a thinner film.

In this case, as compared with the case where only platinum is used as the material of the electrode for electrolysis used in the surface layer as in the conventional example, active oxygen species such as ozone and OH radicals can efficiently be generated. Moreover, the concentration (the component ratio) of comparatively expensive platinum can further be decreased, which can lower the production cost.

As in the manufacturing method of the invention of the sixth aspect, such an electrode for electrolysis is manufactured by forming the surface layer by the sputtering process to form the film on the surface of the base member in the atmosphere including oxygen by use of the target including platinum and silver, whereby the surface layer made of the alloy comprising platinum, silver and oxygen can uniformly be formed on the surface of the base member. In consequence, the surface layer made of the alloy comprising platinum, silver and oxygen and having a uniform thickness can be formed on the whole surface of the base member, whereby the electricity can evenly be conducted over the whole surface of the electrode. This enhances the efficiency of the generation of active oxygen species such as ozone and OH radicals.

### Brief Description of the Drawings

FIG. 1 is a perspective view showing a schematic constitution of an electrode for electrolysis of the present invention;
FIG. 2 is a flowchart showing a manufacturing method of the electrode for electrolysis;
FIG. 3 is a schematic explanatory diagram of an ozone water generation apparatus to which the electrode for electrolysis of the present embodiment is applied;
FIG. 4 shows an experiment result indicating dependency of ozone generation efficiency on Ag concentration;
FIG. 5 shows an X-ray diffraction profile of a surface layer of the electrode for electrolysis;
FIG. 6 is an enlarged diagram of FIG. 5;
FIG. 7 shows an experiment result indicating the dependency of the ozone generation efficiency on the Ag concentration;
FIG. 8 is a perspective view of an electrode for electrolysis as another embodiment;
FIG. 9 is a schematic explanatory diagram of an air cleaner to which the electrode for electrolysis of the present invention is applied; and
' FIG. 10 is a vertical side view of an electric washing machine to which the electrode for electrolysis of the present invention is applied.

### Mode for Carrying out the Invention

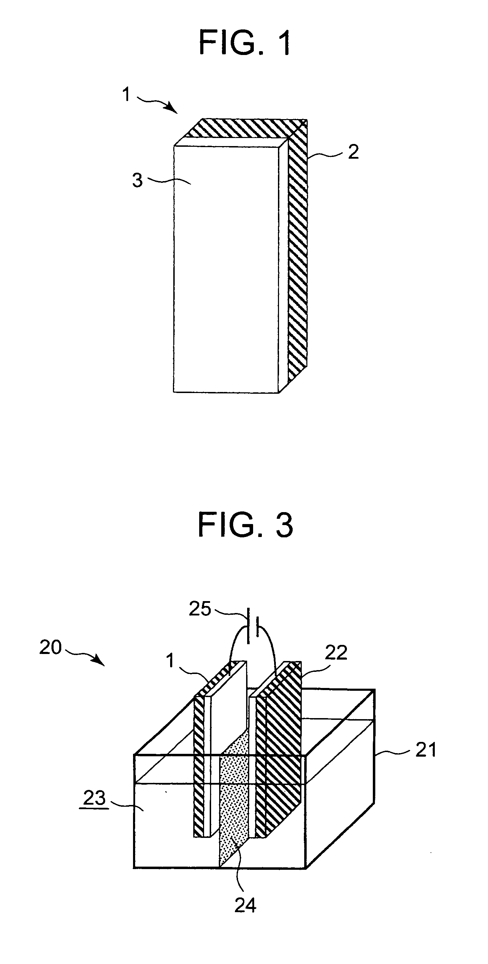

Hereinafter, preferable embodiments of an electrode for electrolysis of the present invention will be described with reference to the drawings. FIG. 1 is a perspective view showing a schematic constitution of an electrode 1 for electrolysis of the present invention. As shown in FIG. 1, the electrode 1 for electrolysis comprises a base member 2 and a surface layer 3 formed on the surface of the base member 2.

In the base member 2 of the present invention, titanium (Ti) is employed as a conductive material. It is to be noted that the material of the base member 2 is not limited to this example, and the material may be made of, for example, platinum (Pt), a valve metal such as tantalum (Ta), zirconium (Zr) or niobium (Nb), an alloy comprising two or more of these valve metals, silicon (Si) or the like.

The surface layer 3 made of an alloy comprising silver (Ag) and platinum (Pt) or an alloy comprising Ag, Pt and oxygen (O) is formed on the surface of the base member 2. The concentrations (wt%) (the component ratios) of Ag and Pt constituting the alloy or the concentrations (wt%) (the component ratios) of Ag, Pt and O constituting the alloy will be described later in detail. The surface layer 3 has a predetermined thickness of, for example, 150 nm.
It is to be noted that the film thickness of the surface layer 3 is appropriately from 100 nm to 10 µm. If the thickness is excessively small, the base member 2 cannot sufficiently be covered with the film made of Ag and Pt, or Ag, Pt and O, which incurs deterioration of durability. Moreover, if the thickness is excessively large, steep rise of cost is caused.

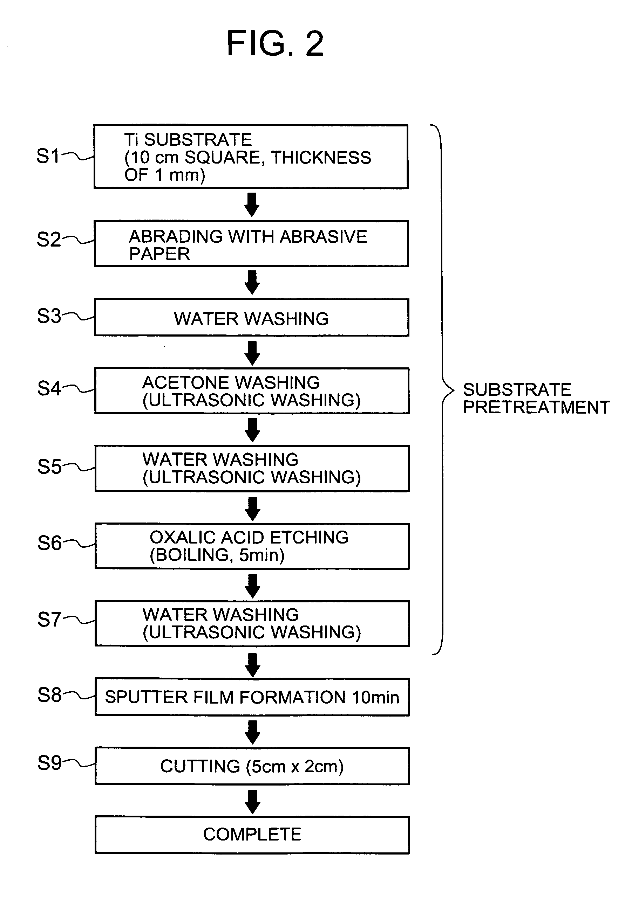

Next, a manufacturing method of the electrode 1 for electrolysis of the present invention will be described with reference to a flowchart of FIG. 2. First, a pretreatment process of a Ti substrate constituting the base member 2 of the electrode 1 for electrolysis is executed. In the pretreatment process, first, in step S1, the Ti substrate used as the material of the base member 2 is processed in a predetermined dimension, for example, a 10 cm square with a thickness of 1 mm in this case. Afterward, in step S2, the surface of the Ti substrate is abraded with abrasive paper, and washed with water (step S3)'. Consequently, contaminants on the surface are removed, thereby performing a flattening treatment of the surface. Furthermore, the surface of the Ti substrate is washed with acetone by ultrasonic washing (step S4) and washed with water by the ultrasonic washing (step S5). Afterward, in step S6, the Ti substrate is subjected to an etching treatment by oxalic acid in a boiling state for five minutes, to remove a naturally oxidized film formed on the surface of the Ti substrate. In consequence, the surface of the base member 2 is brought into a further flattened state. Afterward, in step S7, the surface of the base member 2 is rinsed with pure water (the ultrasonic washing), thereby ending the pretreatment process. At the end of the pretreatment process, the process advances to step S8 to introduce the base member 2 (the Ti substrate) into a chamber of an existing sputter apparatus, thereby forming the film.

In the present embodiment, the surface layer 3 is formed on the base member 2 by a sputter process. Here, a high frequency magnetron sputter apparatus is used to form a thin film of a Pt-Ag alloy on the surface of the base member 2 by simultaneous sputtering of Pt and Ag. As to sputter conditions, since the surface layer 3 is made of the Pt-Ag alloy, a surface layer constituting material comprising Pt having a purity of 3N and Ag having a purity of 3N is used as a target, a high frequency output is set to 100 W, Ar having a purity of 6N or more is used as a sputter gas, and a gas pressure is set to 5 mTorr, thereby executing the film formation at room temperature for ten minutes (step S8). It is to be noted that as to Pt and Ag, predetermined amounts of Pt and Ag having the purities, respectively, are deposited adjacent to each other to form the film on the base member 2 by the sputter process. The use ratio between Pt and Ag will be described later in detail. Moreover, the present invention is not limited to this embodiment, and the film may be formed on the surface of the base member 2 by the sputter process using a target obtained by beforehand mixing Pt and Ag having the predetermined purities at a predetermined ratio.

In consequence, the surface layer 3 having a thickness of about 150 nm is formed on the surface of the base member 2. It is to be noted that as described above, the thickness of the surface layer 3 is not limited to this example, but is appropriately from 100 nm to 10 µm. By the above process, the surface layer 3 having an appropriate thickness, an appropriate amount, a high in-plane uniformity and a predetermined Pt-Ag concentration (wt%) (the component ratio) can be formed on the surface of the base member 2.

It is to be noted that in the present embodiment, the sputter process has been described as an example of the film formation method of the surface layer 3, but the method is not limited to this example. For example, a CVD process, an ion plating process, a laser abrasion process, a plating process, a thermal decomposition process, a thermal spray process or the like may be used.

Afterward, the process advances to step S9 to cut the electrode 1 for electrolysis having the surface layer 3 formed therein into a predetermined dimension, for example, 5 cm x 2 cm. In the present embodiment, the cutting is performed by shear processing, but the cutting is not limited to this example, and press processing by a mold, laser processing or the like may be used.

Next, ozone generation by electrolysis using the electrode 1 for electrolysis manufactured in the above embodiment will be described with reference to FIG. 3.
FIG. 3 is a schematic explanatory diagram of an ozone water generation apparatus 20 to which the electrode 1 for electrolysis of the present embodiment is applied. The ozone water generation apparatus 20 comprises a treatment bath 21, the electrode 1 for electrolysis which is an anode as described above, an electrode 22 which is a cathode, a cation exchange membrane 24, and a power source 25 which applies a direct current to the electrodes 1 and 22. Moreover, in the treatment bath 21, pseudo tap water 23 as an electrolytic solution is stored.

The electrode 1 for electrolysis is prepared by the above manufacturing method. As the electrode 1 for electrolysis used in the ozone water generation apparatus 20, there is used an electrode in which the concentrations (wt%) (the component ratios) of Pt and Ag in the surface layer 3 are varied. Specifically, examples of the used electrode include an electrode comprising. 100 wt% of Pt, an electrode comprising 99 wt% of Pt and 1 wt% of Ag, an electrode comprising 98.5 wt% of Pt and 1.5 wt% of Ag, an electrode comprising 98 wt% of Pt and 2 wt% of Ag, an electrode comprising 97.5 wt% of Pt and 2.5 wt% of Ag, an electrode comprising 97 wt% of Pt and 3 wt% of Ag, an electrode comprising 96 wt% of Pt and 4 wt% of Ag, an electrode comprising 94 wt% of Pt and 6 wt% of Ag, an electrode comprising 92 wt% of Pt and 8 wt% of Ag, an electrode comprising 90 wt% of Pt and 10 wt% of Ag, an electrode comprising 86 wt% of Pt and 14 wt% of Ag, an electrode comprising 72 wt% of Pt and 28 wt% of Ag, an electrode comprising 50 wt% of Pt and 50 wt% of Ag, an electrode comprising 30 wt% of Pt and 70 wt% of Ag, an electrode comprising 10 wt% of Pt and 90 wt% of Ag, and an electrode comprising 100 wt% of Ag. In consequence, the amount of ozone to be generated when each example of the electrode 1 for electrolysis is used as the anode is measured to evaluate each example of the electrode 1 for electrolysis.

It is to be noted that composition analysis of the surface layer 3 of the example of the electrode 1 for electrolysis was performed by fluorescent X-ray analysis. The fluorescent X-ray analysis was performed on measurement conditions that an X-ray tube ball was an Rh target and that an X-ray detector had a detection element range of Na to U, a resolution of 149 eV or less and a measurement range of φ7 mm or less in a vacuum atmosphere.

On the other hand, as the electrode 22 which is the cathode, platinum is used in this case. Alternatively, an electrode having a constitution similar to the electrode 1 for electrolysis may be used as the cathode by changing polarity thereof.

The cation exchange membrane 24 is a film made of a fluorocarbon resin and having a durability with respect to an oxidant such as hydrogen peroxide. Moreover, the electrolytic solution subjected to the electrolysis treatment in the present embodiment is an aqueous solution which simulates tap water, and component composition of the pseudo tap water 23 includes 5.75 ppm of Na⁺, 10.02 ppm of _{Ca}²⁺, 6.08 ppm of Mg²⁺, 0.98 ppm of K⁺, 17.75 ppm of C1⁻, 24.5 ppm of SO₄²⁻ and 16.5 ppm of CO₃²⁻. The water has an electric conductivity of 160 **µ**S/cm.

According to the above constitution, 150 ml of the pseudo tap water 23 having a water temperature of +20°C is disposed on each of an anode side and a cathode side partitioned via the cation exchange membrane 24 in the treatment bath 21, i.e., 300 ml in total is stored. The electrode 1 for electrolysis and the electrode 22 are immersed into the pseudo tap water on the anode side and the cathode side via the cation exchange membrane 24, respectively. It is to be noted that in the present embodiment, each of the electrode 1 for electrolysis and the electrode 22 has an area of 50 mm x 20 mm (an immersed portion of 20 mm x 15 mm), and a length between the electrodes is 10 mm. Moreover, the power source 25 applies a constant current having a current density of about 100. mA/cm² to the electrode 1 for electrolysis and the electrode 22.

It is to be noted that in the present embodiment, as to the amount of ozone to be generated by the electrode 1 for electrolysis, the concentration of ozone in the pseudo tap water 23 after the electrolysis for one minute on the above conditions is measured by using an indigo process (HACH, DR-3000).

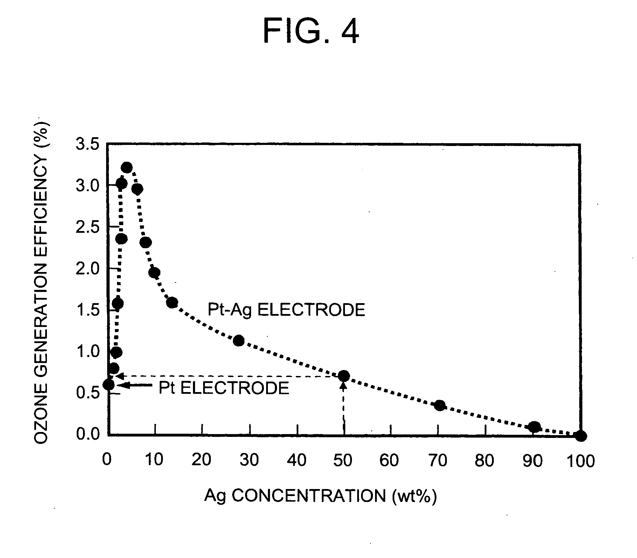

Next, dependency of ozone generation efficiency on Ag concentration (wt%) (the component ratio) will be described with reference to FIG. 4. FIG. 4 shows ozone generation ratios of the above examples of the electrode 1 for electrolysis on the same conditions described above in the present embodiment. In FIG. 4, the ordinate indicates the ozone generation ratio (%), and the abscissa indicates the concentration (wt%) (the component ratio) of Ag constituting the surface layer 3 of the electrode 1 for electrolysis.

According to the experiment result of FIG. 4, the ozone generation ratio is about 0.6% in a case where the surface layer 3 of the electrode 1 for electrolysis comprises only Pt, whereas the ozone generation ratio rises, when the Ag concentration gradually rises. In the experiment of FIG. 4, when the Ag concentration is 4 wt%, the ozone generation ratio reaches a peak of about 3.2%. Afterward, when the Ag concentration gradually rises, the ozone generation ratio decreases, and when the Ag concentration is 14 wt%, the ozone generation ratio is about 1.6%. When the Ag concentration is 28 wt%, the ozone generation ratio is about 1.2%. When the Ag concentration is 50 wt%, the ozone generation ratio is about 0.7%. Afterward, when the Ag concentration gradually rises, the ozone generation ratio gradually lowers. In the electrode for electrolysis comprising 100 wt% of Ag, the ozone generation ratio is 0%, and Ag is immediately dissolved. It is to be noted that in any case, when ozone is generated, active oxygen species such as OH radicals are simultaneously generated.

In this case, when the Ag concentration of the Pt-Ag surface layer 3 is from 1 wt% or more to 50 wt% or less, the ozone generation ratio is about 0.7% or more, and it can be considered that the ozone generation ratio is high as compared with a case where the surface layer 3 of the electrode 1 for electrolysis comprises only Pt. In particular, when the Ag concentration is from 2 wt% or more to 14 wt% or less, the ozone generation ratio is about 1.5% or more, and the ozone generation ratio can further be raised. Moreover, when the Ag concentration is from 3 wt% or more to 6 wt% or less, the ozone generation ratio is about 2.9% or more, and the ozone generation ratio can remarkably be raised.

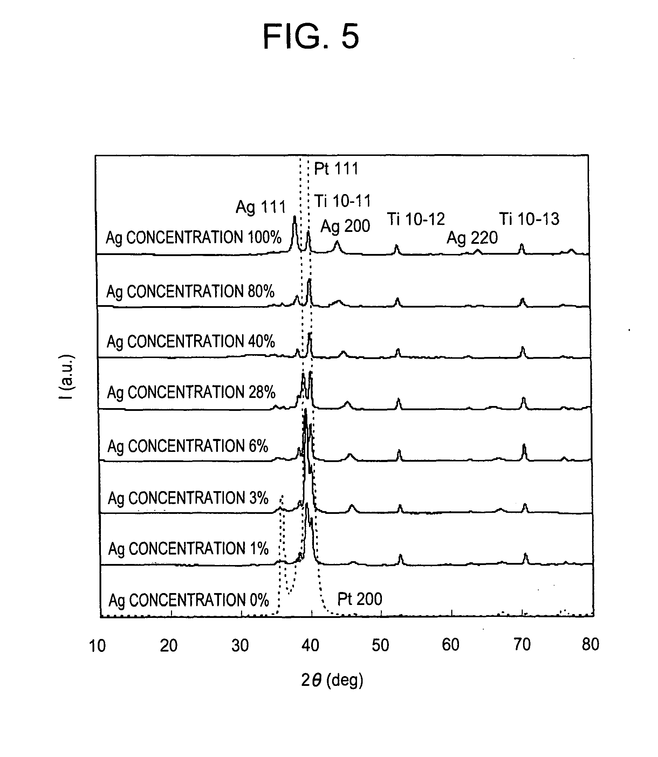

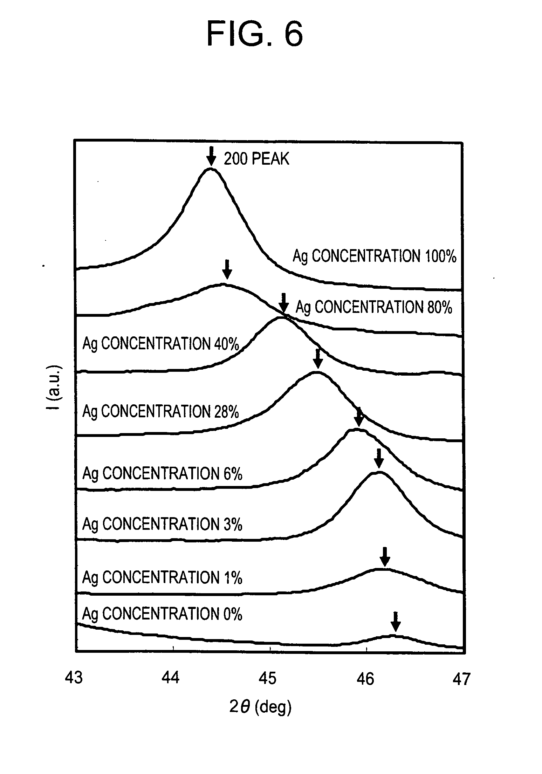

Here, there will be considered a crystal structure of the surface layer 3 of each example of the electrode 1 for electrolysis in a case where the Ag concentration is varied with respect to Pt constituting the surface layer 3. FIG. 5 shows an X-ray diffraction profile of the Ag concentrations of the electrode for electrolysis, and FIG. 6 shows an enlarged X-ray diffraction profile of FIG. 5, in which 2θ is from 43° to 47°.

In this case, each example of the electrode 1 for electrolysis was subjected to the crystal structure analysis by an X-ray diffraction measurement process in a case where the concentration of Ag with respect to Pt was set to 0 wt%, 1 wt%, 3 wt%, 6 wt%, 28 wt%, 40 wt%, 80 wt% and 100 wt%. Conditions of the X-ray diffraction measurement were an X-ray source used as a Cu rotor target, 45 kV, 360 mA, a slit having a dimension of 1.0 mm x 5 mm on an incident side, a parallel soller slit (0.12 deg) on a detector side, and a θ-2θ process employed as a measurement method.

According to this analysis, in an X-ray diffraction pattern of the electrode 1 for electrolysis in which the surface layer 3 comprises 100 wt% of Pt, as shown in the lowermost stage of each diagram, as a diffraction peak (2θ), the peak of Pt (111) is seen around 39.6°. Moreover, the peak of Pt (200) is seen at 46.3°. In an X-ray diffraction pattern of the electrode 1 for electrolysis in which the surface layer 3 comprises 100 wt% of Ag, as shown in the lowermost stage of each diagram, as the diffraction pattern (2θ), the peak of Ag (111) is seen around 38.2°, the peak of Ag (200) is seen around 44.4°, and the peak of Ag (220) is seen around 64.7°.

Moreover, it is shown that the concentration of Ag with respect to Pt of the surface layer 3 is raised from an upper stage to a lower stage. Here, variance of the peak between the Ag (200) peak and the Pt (200) peak indicating characteristic variances will be considered. It is seen that the Pt (200) peak around 46.3° at 100 wt% of Pt gradually becomes small when the Ag concentration is raised and that the peak comes close to the Ag (200) peak around 44.4° at 100 wt% of Ag.

The crystal structures of Pt and Ag constituting the surface layer are both face-centered cubic (fcc) structures. Attention will be focused on the abovementioned variance of the position of the Ag (200) peak accompanying the variance of the Ag concentration (wt%).
It is seen that with the increase of the Ag concentration (wt%), the diffraction angle 2θ continuously varies between 46.3° of Pt and 44.4° of Ag. According to this result, when the concentration of Ag with respect to Pt is raised, Pt and Ag are alloyed while maintaining the face-centered cubic structure as the crystal structure.

Therefore, when only Ag is singly present in the surface layer 3, a corrosion resistance is not sufficiently acquired. However, according to the analysis of such a crystal structure, Ag and Pt constituting the surface layer 3 of the electrode 1 for electrolysis are alloyed, thereby noticeably improving the corrosion resistance.

It is also seen that a crystal lattice constant continuously varies from 0.3923 nm in the case of 100 wt% of Pt to 0.4078 nm in the case of 100 wt% of Ag. In consequence, when the above dependency of the ozone generation efficiency on the Ag concentration is taken into consideration, it can be presumed from the above experiment result that unlike the surface layer 3 comprising 100 wt% of Pt, the concentration of Ag with respect to Pt is raised as much as a predetermined amount in a range of 1 wt% to 50 wt%, whereby the crystal structure constituting the surface layer 3 has the lattice constant increased in a predetermined range as compared with the crystal structure comprising only Pt, but such a lattice constant and the ratio between Ag and Pt constituting the alloy contribute to remarkable enhancement of the ozone generation efficiency.

In consequence, the material of the electrode for electrolysis which is the alloy comprising Pt and Ag and having the Ag concentration from 1 wt% or more to 50 wt% or less is used as the surface layer 3 formed on the surface of the base member 2, whereby in the electrolysis by the electrode 1 for electrolysis, active oxygen species such as ozone and OH radicals can be generated with a high current efficiency. Therefore, as compared with the conventional example, the amount of the power necessary for generating the same amount of ozone can be decreased, which can contribute to energy saving. Moreover, as compared with an electrode for electrolysis having an equal dimension, active oxygen species such as ozone and OH radicals can efficiently be generated with a low current density, the electrode wears less, and the improvement of durability can be realized. When the electrolysis treatment is performed with the same current density, the dimension of the electrode for electrolysis itself can be decreased. Moreover, since the electrode wears less, the surface layer 3 can have a constitution of a thinner film.

Moreover, as compared with a case where only Pt is used as the material of the electrode for electrolysis used in the surface layer as in the conventional example, active oxygen species such as ozone and OH radicals can efficiently be generated. Moreover, the concentration (the component ratio) of comparatively expensive Pt can be lowered, which can lower production cost. Furthermore, the material does not have to be processed into a mesh or porous state to enlarge the surface area of the electrode for electrolysis, but ozone can highly efficiently be generated as compared with the conventional electrode for electrolysis comprising only Pt, which also can lower the production cost.

Furthermore, in the present embodiment, the electrode 1 for electrolysis has a constitution in which the surface layer 3 is formed by the sputter process of forming the film on the surface of the base member 2 by use of the base member 2 as a sample and using a target including Pt and Ag, whereby the surface layer 3 made of the alloy comprising Pt and Ag can uniformly be formed on the surface of the base member 2. In consequence, since the surface layer 3 made of the alloy comprising Pt and Ag and having a uniform thickness can be formed on the whole surface of the base member 2, electricity can evenly be conducted through the whole surface of the electrode 1, which can achieve the enhancement of the generation efficiency of active oxygen species such as ozone and OH radicals.

It is to be noted that the alloy of Ag and Pt constituting the surface layer 3 is not limited to this example, and the surface layer may be made of an alloy obtained by adding oxygen (O) to Ag and Pt. In this case, the surface layer 3 is formed by using a sputter gas comprising Ar having a purity of 6 N or more and O₂ having a purity of 6 N or more in addition to the above sputter conditions. In this case, the flow rate of O₂ of the sputter gas to be introduced into the chamber of the sputter apparatus is set so that the concentration of oxygen is from 15% to 19%.

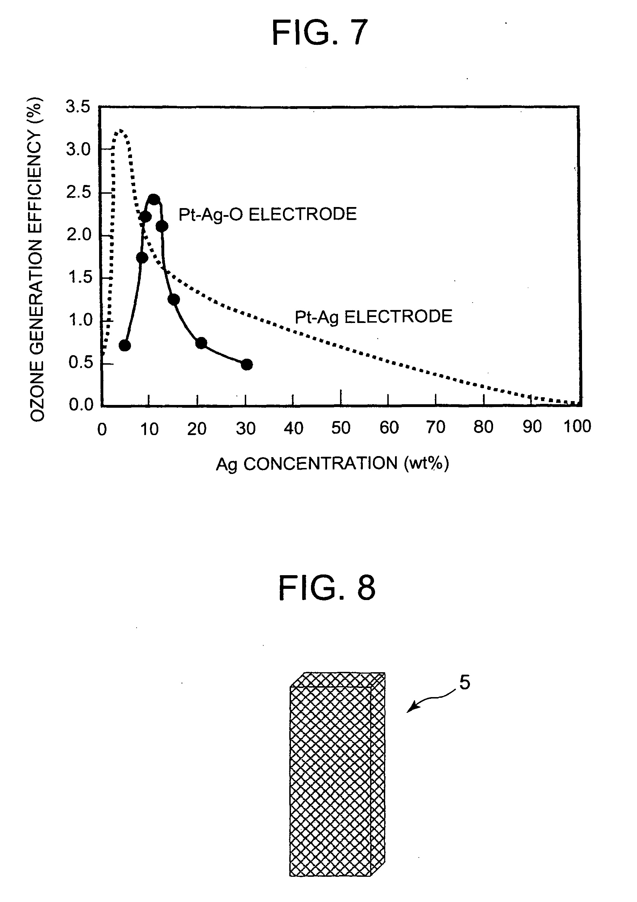

FIG. 7 shows the dependency of the ozone generation efficiency of the electrode 1 for electrolysis made of the alloy of Pt-Ag-O on the Ag concentration (wt%). It is to be noted that to facilitate comparison with the concentration ratio of Pt-Ag in FIG. 4, wt% of Ag in a case where the total amount of Pt and Ag is 100% is shown as the Ag concentration.

In this case, the ozone generation ratio is about 0.6% in a case where the surface layer 3 of the electrode 1 for electrolysis comprises only Pt, whereas the ozone generation ratio rises, when the Ag concentration gradually rises. In the experiment of FIG. 7, when the Ag concentration is 5 wt%, the ozone generation ratio is about 0.7%. When the Ag concentration is 9 wt%, the ratio is 1.8%. When the Ag concentration is 10 wt%, the ratio is 2.2%. When the Ag concentration is 11 wt%, the ratio is 2.4%. When the Ag concentration is 12 wt%, the ratio is 2.1%. When the Ag concentration is 15 wt%, the ratio is 1.3%. When the Ag concentration is 21 wt%, the ratio is 0.8%. When the Ag concentration is 30 wt%, the ratio is 0.5%.

In FIG. 7, a dotted line shows a case where the electrode 1 for electrolysis of Pt-Ag is used as shown in FIG. 4. In this case, it is seen that as compared with a case where the surface layer 3 of the electrode 1 for electrolysis comprises only Pt, also in a case where the surface layer is made of the alloy obtained by adding oxygen to Pt-Ag, active oxygen species such as ozone and OH radicals can more efficiently be generated. In particular, as compared with a case where only Pt is used in the surface layer 3, when the Ag concentration is from 5 wt% to 21 wt%, the ozone generation efficiency is high. Furthermore, when the Ag concentration is from 9 wt% to 12 wt%, the ozone generation efficiency becomes higher.

Therefore, also when the material of the electrode for electrolysis which is the alloy comprising Pt-Ag-0 and having an Ag concentration from 1 wt% or more to 50 wt% or less is used as the surface layer 3 formed on the surface of the base member 2, in the electrolysis by the electrode 1 for electrolysis, active oxygen species such as ozone and OH radicals can efficiently be generated with the low current density.

In this case, as compared with the case where only platinum is used as the material of the electrode for electrolysis used in the surface layer as in the conventional example, active oxygen species such as ozone and OH radicals can efficiently be generated. Moreover, the concentration (the component ratio) of comparatively expensive platinum can further be lowered, which can lower the production cost. Since oxygen is added, the ozone generation efficiency with respect to the Ag ratio lowers as compared with a case where the surface layer 3 comprises only Pt-Ag. However, when the electrode for electrolysis is used for generating ozone in a predetermined range, the amount of Pt or Ag to be used can be decreased, which can lower the production cost.

It is to be noted that the electrode 1 for electrolysis in the above embodiment has the constitution in which the surface layer 3 is formed by the sputter process of forming the film on the surface of the base member 2 in an atmosphere including oxygen by use of the base member 2 as the sample and the target including Pt and Ag, whereby the surface layer 3 made of the alloy comprising Pt, Ag and O can uniformly be formed on the surface of the base member 2. In consequence, since the surface layer 3 of the alloy comprising Pt, Ag and O and having a uniform thickness can be formed on the whole surface of the base member 2, the electricity can evenly be conducted through the whole surface of the electrode, which can achieve the enhancement of the generation efficiency of active oxygen species such as ozone and OH radicals.

It is to be noted that in the above embodiment, as the example, there has been described the plate electrode 1 for electrolysis having a constitution in which the surface layer 3 made of the alloy comprising Ag and Pt having the predetermined concentrations (wt%) (the component ratios) or the alloy comprising Ag, Pt and O having the predetermined concentrations (wt%) (the component ratios) is formed on the surface of the base member 2, but the present invention is not limited to this example. For example, as shown in FIG. 8, the electrode may be an electrode 5 for electrolysis having a constitution in which a surface layer made of an alloy comprising Ag and Pt having predetermined concentrations (wt%) (the component ratios) or an alloy comprising Ag, Pt and O having predetermined concentrations (wt%) (the component ratios) is formed on the surface of a base member made of a valve metal such as Ti and formed in a mesh state. It is to be noted that the present invention is not limited to the mesh electrode, and additionally, the electrode may be a porous electrode, a rod electrode, a wire electrode or a strip electrode. Moreover, the present invention is not limited to the constitution in which the surface layer made of the alloy comprising Ag, Pt and the like is formed on the surface of the base member. Also when the alloy comprising Ag and Pt having the predetermined concentrations (wt%) (the component ratios) or the alloy comprising Ag, Pt and O having the predetermined concentrations (wt%) (the component ratios) is used as a material of an electrode catalyst (the material of the electrode for electrolysis), a similar effect can be produced.

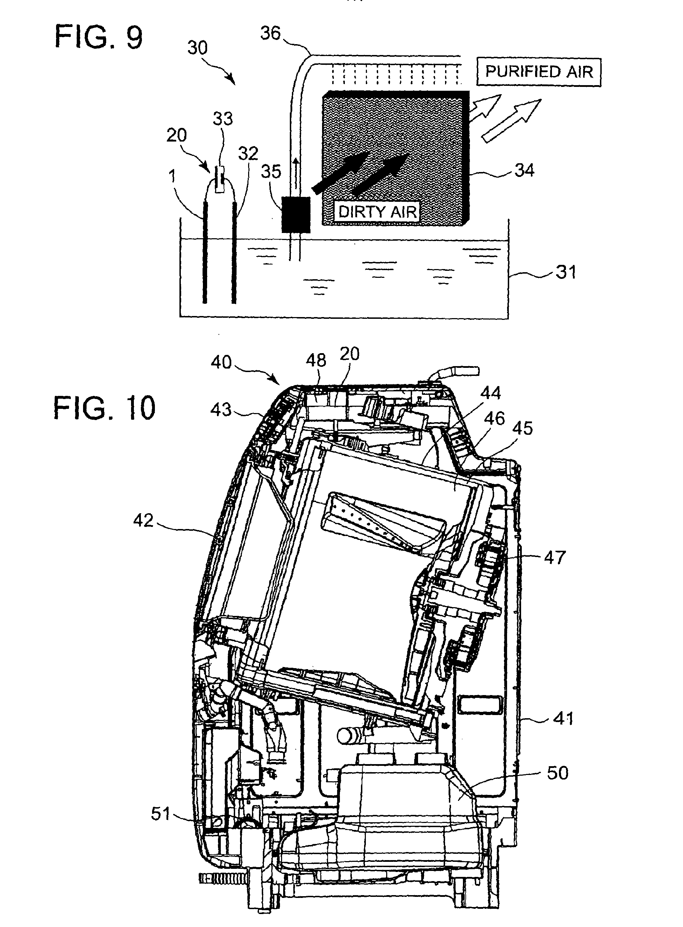

Next, an air cleaner 30 to which the ozone water generation apparatus 20 using the electrode 1 for electrolysis is applied will be described with reference to FIG. 9. FIG. 9 shows a schematic explanatory diagram of the air cleaner 30. The air cleaner includes a water tank 31, and the electrode 1 for electrolysis constituting the anode as described above and an electrode 32 constituting a cathode are immersed into water stored in the water tank 31. In this case, as the electrode 32, an electrode having a surface layer of Pt formed on a Ti substrate is employed.
A direct current power source 33 supplies a constant current of 100 mA to 500 mA to the electrodes 1 and 32 during a usual operation. It is to be noted that the power source 33 may be a constant voltage power source.

In the air cleaner 30, an air filter 34 through which in-chamber air flows is disposed, and a conduit tube 36 provided with a pump 35 conveys electrolytic water from the water tank 31 above the air filter 34 to drop the water down to the air filter 34.

According to such a constitution, when the power source 33 of the ozone water generation apparatus 20 allows a direct current to flow through the electrode 1 constituting the anode and the electrode 32 constituting the cathode, the electrolytic water including active oxygen species such as ozone and OH radicals is generated in the water tank 31. Subsequently, this electrolytic water is dropped down to the air filter 34 through the conduit tube 36 by the pump 35. In consequence, the in-chamber air circulated and fed through the air filter 34 by a blower (not shown) is purified and subjected to a bacteria sterilization treatment while passing through the air filter 34. As an anode of the ozone water generation apparatus 20, the electrode 1 for electrolysis is employed which can highly efficiently generate ozone with a low current as described above, so that active oxygen species such as ozone can stably be generated. An air purifying function or a bacteria sterilization function can be exerted over a long period of time.

Next, there will be described an electric washing machine employing the ozone water generation apparatus 20 in which the electrode 1 for electrolysis of the present invention is employed as described above, with reference to FIG. 10. FIG. 10 is a vertical side view of an electric washing machine 40. In the electric washing machine 40, a washing tank 44 is disposed in the upper part of a housing 41 constituting an outer shell, and a water storage tank 50 is disposed in the lower part of the washing tub. In the upper part of the front surface of the housing 41, a housing opening 41A is formed, and is openably closed by a door 42. In the drawing, a control panel 43 is disposed in the upper part of the front surface of the housing 41.

The electric washing machine 40 is provided with the washing tank (a storage chamber) 44, and the washing tank 44 comprises an outer tank 45 and a cylindrical drum (an inner tank) 46 disposed in the outer tank 45 to receive laundry. Moreover, a DD motor 47 is disposed on the back surface of the outer tank 45 so that the drum 46 can be rotated in the outer tank 45 by the DD motor 47.

A water inlet unit 48 is disposed above the outer tank 45. The water inlet unit 48 is a unit through which washing water or rinsing water to be introduced into the outer tank 45 passes, and comprises the ozone water generation apparatus 20 described above. It is to be noted that the ozone water generation apparatus 20 has substantially the same constitution as that in the air cleaner 40.

The water storage tank 50 disposed under the washing tank 44 is configured to receive water discharged from the outer tank 45 or bath water pumped by a bath water pump (not shown). In the vicinity of the water storage tank 50, a circulation pump 51 for pumping the water from the water storage tank 50 is provided. In the ozone water generation apparatus 20, the water fed through the water inlet unit 48 is once received, while the direct current from the direct current power source 33 flows through the electrode 1 for electrolysis constituting the anode and the electrode 32 constituting the cathode as described above, whereby ozone is generated in the water fed through the water inlet unit 48. This ozone water is fed into the outer tank 45 during washing or rinsing. In consequence, the electric washing machine 40 can execute a washing/rinsing operation by the ozone water generated in tap water.

It is to be noted that the embodiment employing the electrode 1 for electrolysis of the present invention is not limited to the air cleaner 30 and the electric washing machine 40, and is effective for each apparatus in which an ozone water containing ozone having a predetermined concentration is used, for example, an ozone water generator. When a mesh electrode is used in this ozone water generator, a barrier membrane may be used to acquire a zero gap. On the other hand, when any mesh electrode is not used, plate electrodes for electrolysis may desirably be arranged to face each other with a space of 0.1 to 10 mm therebetween. At this time, the barrier membrane may be or may not be used.

### Description of Reference Numerals

- 1, 5: electrode for electrolysis
- 2: base member
- 3: surface layer
- 20: ozone water generation apparatus
- 21: treatment bath
- 22: electrode
- 23: pseudo tap water
- 24: cation exchange membrane
- 25: power source

## Claims

1. A material of an electrode for electrolysis which is an alloy comprising platinum and silver, wherein concentration of silver is from 1 wt% or more to 50 wt% or less.

2. A material of an electrode for electrolysis which is an alloy comprising platinum, silver and oxygen, wherein concentration of silver is from 1 wt% or more to 50 wt% or less.

3. An electrode for electrolysis comprising:
a base member; and
a surface layer formed on the surface of the base member,
wherein the surface layer is made of an alloy comprising platinum and silver, and concentration of silver is from 1 wt% or more to 50 wt% or less.

4. An electrode for electrolysis which generates active oxygen species of ozone and OH radicals by the electrolysis, the electrode comprising:
a base member; and
a surface layer formed on the surface of the base member,
wherein the surface layer is made of an alloy comprising platinum, silver and oxygen, and concentration of silver is from 1 wt% or more to 50 wt% or less.

5. A manufacturing method of the electrode for electrolysis according to claim 3, which comprises forming the surface layer by a sputtering process to form a film on the surface of the base member by use of a target including platinum and silver.

6. A manufacturing method of the electrode for electrolysis according to claim 5, which comprises forming the surface layer by a sputtering process to form a film on the surface of the base member in an atmosphere including oxygen by use of a target including platinum and silver.
